# EUROPÄISCHE PATENTSCHRIFT

(11) **EP 0 623 258 B1**
(45) Veröffentlichungstag und Bekanntmachung des Hinweises auf die Patenterteilung: **02.04.1997**
(21) Anmeldenummer: 93901623.4
(22) Anmeldetag: 08.01.1993
(51) Int. Cl.: H03K 17/945

(54) **NÄHERUNGSSCHALTER MIT ANPASSUNG AN SENSORGRÖSSE**
PROXIMITY SWITCH ADAPTABLE TO VARIOUS SENSOR SIZES
COMMUTATEUR DE PROXIMITE ADAPTABLE A DIFFERENTES TAILLES DE CAPTEURS

(30) Priorität: 23.01.1992 DE 9200770 U
(43) Veröffentlichungstag der Anmeldung: 09.11.1994
(73) Patentinhaber: SIEMENS AKTIENGESELLSCHAFT, 80333 München (DE)
(72) Erfinder: FEUERER, Johann, D-8411 Brunn (DE); BÄUML, Alfred, D-8640 Schwandorf (DE); SCHMITT, Manfred, D-8451 Hahnbach (DE); GASSNER, Robert, D-8400 Regensburg (DE); BÄUMLER, Michael, D-8480 Weiden (DE); LIST, Konrad, D-8458 Sulzbach-Rosenberg (DE); PETRY, Heinrich, D-8524 Neunkirchen (DE)
(86) Internationale Anmeldenummer: DE9300005
(87) Internationale Veröffentlichungsnummer: WO9315554

(56) Entgegenhaltungen:
- DE-A- 3 321 666
- DE-A- 3 539 252
- DE-C- 3 028 939
- DE-C- 3 129 120
- DE-U- 8 233 796
- FR-A- 2 643 640

## Beschreibung

Die Erfindung bezieht sich auf einen Näherungsschalter mit einem eine Bohrung vom Innendurchmesser D aufweisenden Gehäuse, in dessen Innenraum am einen Ende ein elektrisches Anschlußteil und am anderen Ende ein Sensor aufgenommen ist, mit einer elektrischen Schaltung im Zwischenraum zwischen dem Anschlußteil und dem Sensor und mit einer wärmeleitenden Verbindung zwischen der elektrischen Schaltung und dem Gehäuse.

Ein derartiger Näherungsschalter ist aus der Offenlegungsschrift DE-OS 33 21 666 A1 bereits bekannt. Hier ist ein Näherungsschalter mit einer Gewindehülse aus Kunststoff oder Metall beschrieben, in die eine elektrische Schaltung in Form eines Hybrids eingeführt ist. Die Gewindehülse wird nach dem elektrischen Anschluß in bekannter Weise mit Kunststoff ausgegossen. Solange die üblicherweise scheibenförmig ausgebildeten Sensoren nur eine geringe Ausdehnung im Durchmesser aufweisen, bereitet die Ableitung der Wärme aus dem Innenraum der Hülse, die nach dem Vergießen beim Aushärten des Kunststoffes und beim Betrieb des Näherungsschalters erzeugt wird, keine besonderen Schwierigkeiten. Demgegenüber ist jedoch bei Verwendung von Sensoren mit größeren Abmessungen der Aufbau des Näherungsschalters mit einer Hülse wegen der erschwerten thermischen Ableitung weniger geeignet. Eine bloße Anpassung der Größe der Hülse an die vorgegebenen vergrößerten Abmessungen des Sensors würde daneben das Problem mit sich bringen, daß an die nun vergrößerte Öffnung der Hülse angepaßte elektrische Anschlußteile vorgesehen werden müßten.

Aus der DE 31 29 120 C1 ist ein Näherungsschalter bekannt, bei dem Bauelemente auf einer Schaltungsplatine in einer elastischen Masse eingebettet sind, die zwischen den Bauteilen und der Schaltungplatine und einer als Gehäuse dienenden Umhüllungsmasse liegt.

Der in der DE 35 39 252 Al offenbarte Näherungsschalter weist ein becherförmig ausgebildetes Gehäuseteil auf, an dessem Boden eine Schalenkernanordnung mit einer Wicklung angeordnet ist und das mit einer umlaufenden Schulter versehen ist, welche an der freien Stirnfläche einer als Gehäuse dienenden Metallhülse anliegt.

Dem Dokument DE-U 82 33 796.9 ist ein induktiver Näherungsschalter zu entnehmen, dessen Kern aus einem Ferrittopf und einem magnetischen Kurzschlußjoch besteht. Die innerhalb des Ferrittopfes liegende Wicklung ist über eine Oszillatorschaltung mit einer elektronischen Auswerteschaltung verbunden. Das als Metallhülse ausgebildete Gehäuse ist den Abmessungen der vorgenannten Komponenten angepaßt, d.h. in einem stirnseitig erweiterten Hohlraum liegt das Kurzschlußjoch, während im anschließenden engeren zylinderförmigen Hohlraum der Oszillatorschwingkreis sowie die elektronische Auswerteschaltung untergebracht sind. Die als Gehäuse dienende Metallhülse ist relativ dünnwandig bei stets gleicher Wandstärke ausgebildet.

Der Erfindung liegt die Aufgabe zugrunde, einen Näherungsschalter der obengenannten Art zu schaffen, der eine einfache Anpassung an unterschiedliche Sensorgrößen ermöglicht, der die Verwendung von in ihrer Ausführung unveränderten elektrischen Schaltungen und Anschlußteilen für unterschiedliche Sensorgrößen ermöglicht und zudem gute thermische Ableitungswege bietet. Die vorgenannte Aufgabe wird mit einem Näherungsschalter nach Anspruch 1 gelöst. Diese Ausführungsform zeichnet sich durch das stets kleingehaltene Innenraumvolumen, unabhängig von der Sensorgröße, besonders vorteilhaft aus. Die Größe des Innenraumvolumens bestimmt nämlich die beim Aushärten der Vergußmasse und im Betrieb erzeugte Wärme, die umso stärker ist, je größer der Innenraum und damit die erforderliche Menge an Vergußmasse ist, um diesen auszufüllen. Bei kleinerem Innenraumvolumen können kostengünstige, weniger gut warme-, dafür aber lichtleitende Vergußmassen verwendet werden, die zur Lichtübertragung einer im Innenraum liegenden Leuchtdiode für eine Schaltzustandsanzeige geeignet sind. Zum Verguß größerer Innenräume muß dagegen auf besonders gut wärmeleitende Vergußmassen zurückgegriffen werden, um allzu große Temperaturunterschiede und damit Wärmespannungen beim Aushärten der Vergußmasse und beim Betrieb der elektrischen Schaltung zu vermeiden. Zudem erweist sich die vorgenannte Lösung als kostengünstig, da wegen der Verwendung stets gleicher elektrischer Anschlußteile und elektrischer Schaltungen geringere Lagerhaltungskosten anfallen.

Weiterhin erweist es sich als zweckmäßig, wenn der Massivkörper eine kreisförmige Außenkontur aufweist, da diese besonders leicht bereitzustellen ist und für den späteren Einbau des Näherungsschalters besonders vorteilhaft ist. Aufgrund der üblicherweise scheibenförmigen Ausbildung des Sensors ist es besonders einfach und zweckmäßig, auch im Hinblick auf die Fertigung, wenn die Ausweitung als zweite zur ersten Bohrung axialsymmetrische Bohrung ausgeführt ist.

Eine für die Befestigung zweckmäßige Ausführungsform wird erreicht, wenn der Massivkörper an dem das elektrische Anschlußteil aufweisenden Ende axialsymmetrisch zur ersten Bohrung ein Außengewinde aufweist. Dies bedeutet, daß der Näherungsschalter bei der vorbeschriebenen Bauform, unabhängig von dem jeweils verwendeten Sensor, stets mit der gleichen Schraubbefestigung ausgestattet ist, was somit eine kundenfreundliche Lösung darstellt. Zur Überwachung und Gewährleistung eines sicheren Betriebs erweist es sich als nützlich, wenn der Näherungsschalter eine.Schaltzustandsanzeige aufweist.

Es ist weiterhin vorteilhaft, wenn das elektrische Anschlußteil als lichtleitender Steckereinsatz ausgeführt ist, der das Licht einer Leuchtdiode im Innenraum zu mindestens einer dritten Bohrung im Massivkörper überträgt, durch die das Licht der Leuchtdiode von außen her erkennbar ist. Bei dieser Bauform kann die Leuchtdiode in den durchsichtigen Steckereinsatz eingeschoben werden, so daß hierdurch eine kurze Bauform ermöglicht wird. Der lichtleitende und gegebenenfalls durchsichtige Steckereinsatz ermöglicht es außerdem, daß das Licht der Leuchtdiode allseitig übertragen wird und somit über am Umfang des Massivkörpers verteilte dritte Bohrungen der Schaltzustand ebenfalls von mehreren Seiten erkennbar ist.

Ist die dritte Bohrung vom Innenraum nach außen im hülsenförmigen Abschnitt des Massivkörpers vorgesehen, so ergeben sich hiermit kurze Übertragungswege und damit eine entsprechend geringe Dämpfung der Intensität des von der Leuchtdiode ausgestrahlten Lichts. Daneben ist auch eine Ausführungsform zweckmaßig, bei der als elektrisches Anschlußteil ein Kabel mit einem gegenüber D kleineren Außendurchmesser vorgesehen ist und der Innenraum mit einer durchsichtigen Vergußmasse vergossen ist, über die das Licht einer Leuchtdiode im Innenraum zu der zwischen dem Massivkörper und dem Kabel befindlichen Fläche am Austritt des Kabels übertragbar ist. Auf diese Weise wird demzufolge auch bei einem Kabelanschluß eine einfache Schaltzustandsanzeige gewährleistet.

Weiter Einzelheiten und Vorteile der Erfindung werden nachstehend anhand einer Zeichnung näher erläutert.

Es zeigen:
- FIG 1: einen Längsschnitt durch einen Näherungsschalter mit einem Steckereinsatz,
- FIG 2: einen Längsschnitt durch einen Näherungsschalter mit einem Kabelanschluß.

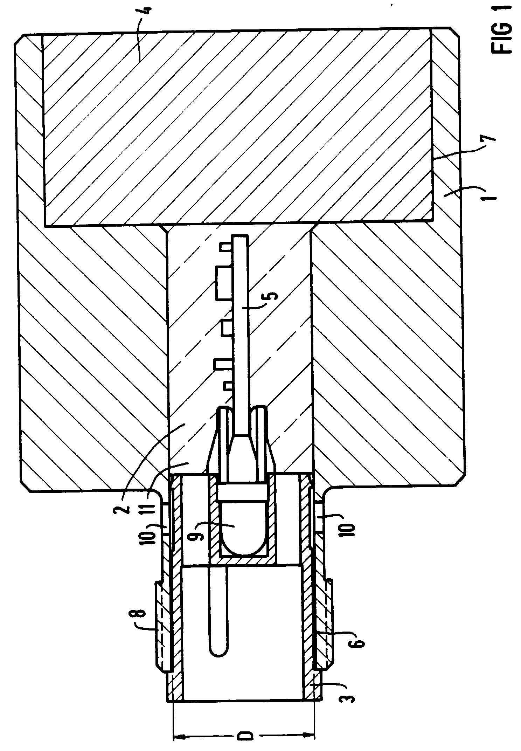

FIG 1 zeigt ein als metallischer Massivkörper 1 ausgeführtes Gehäuse eines Näherungsschalters, das eine kreisförmige Aussenkontur aufweist, zu der axialsymmetrisch eine erste Bohrung 6 mit einem Innendurchmesser D verläuft. An der einen Stirnseite des Massivkörpers 1 ist axialsymmetrisch zur ersten Bohrung 6 eine im Durchmesser größere zweite Bohrung 7 vorgesehen. Die andere Stirnseite des Massivkörpers 1 ist im Endbereich zu einer Hülsenform verjüngt. Dieser Bereich trägt ein Außengewinde 8 sowie mehrere Bohrungen 10. Im Bereich der Bohrung 7 ist ein Sensor 4 eingelassen, der mit einer elektrischen Schaltung 5 verschaltet ist, die sich in dem anschließenden durch die Bohrung 6 vorgegebenen Innenraum befindet. Diese besteht im vorliegenden Fall aus einer mit elektrischen Bauelementen bestückten Leiterplatte, die auf ihrer anderen Seite über einen im verjüngten Bereich des Massivkörper 1 liegenden Steckereinsatz 3 elektrisch versorgt wird. Der Steckereinsatz 3 ist durchsichtig und lichtleitend und weist eine Öffnung zur Aufnahme einer mit der Leiterplatte 5 kontaktierten Leuchtdiode 9 auf. Die Leuchtdiode 9 ist den Bohrungen 10 möglichst nahe gegenüber gelegen. Der Innenraum im Bereich der elektrischen Schaltung ist mit einer Vergußmasse 11 ausgefüllt. Während die Öffnung 7 durch die Größe des Sensors 4 bestimmt ist, ist der Innenraum zur Aufnahme der elektrischen Schaltung 5 und des elektrischen Anschlußteils 3 durch eine Bohrung vom Durchmesser D möglichst kleingehalten. Somit wird zum Verguß nur eine geringe Menge an Vergußmasse 11 benötigt, wodurch es beim Aushärten und im Betrieb des Näherungsschalters nur zu geringen und unschädlichen Temperaturspannungen kommt. Somit wird eine hohe Zuverlassigkeit der elektrischen Schaltung und des Betriebs des Näherungsschalters sichergestellt. die Verwendung eines metallischen Massivkörpers gewährleistet zudem eine besonders gute Wärmeableitung.

Die Ausführung des elektrischen Anschlußteils in Form eines durchsichtigen, lichtleitenden Steckeinsatzes 3 in Verbindung mit der Leuchtdiode 9 und den Bohrungen 10 am Umfang im verjüngten Bereich des Gehäuses bietet eine allseitig sichtbare Schaltzustandsanzeige des Näherungsschalters.

Der kreisförmige Massivkörper 1 ist im Aufnahmebereich des Sensors 4 und der elektrischen Schaltung 5 mit einem Außengewinde versehen, über den der Näherungsschalter kundenseitig am Einsatzort befestigbar ist.

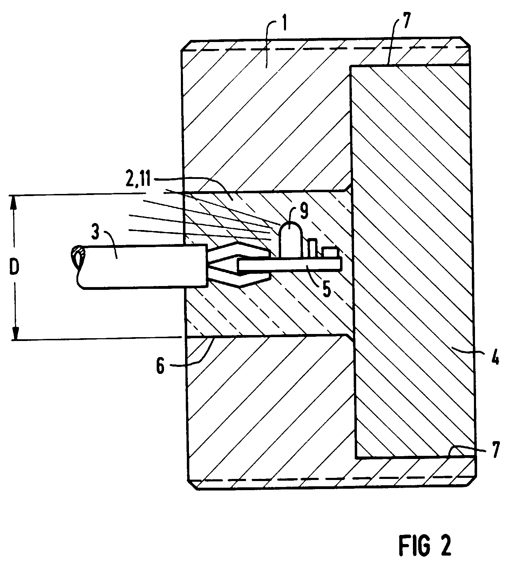

In FIG 2 ist ein elektrischer Näherungsschalter mit einem Kabel 3 als elektrisches Anschlußteil dargestellt, der im Aufbau grundsätzlich mit dem in FIG 1 gezeigten Näherungsschalter übereinstimmt. Auch hier ist ein Massivkörper 1 als Gehäuse mit einer Bohrung 6 zur Aufnahme der elektrischen Schaltung 5 und des Kabels 3 versehen. Ein Sensor 4 ist in einer ausgehend von der Bohrung 6 aufgeweiteten Bohrung 7 aufgenommen. Gegenüber der obengenannten Ausführungsform ist hier kein hülsenförmiger Abschnitt im Bereich des elektrischen Anschlußteils 3, d.h. des Kabels 3 vorgesehen. Stattdessen weist der Näherungsschalter über seine gesamte Länge denselben Außendurchmesser auf.

Der durch die Bohrung 6 gebildete Innenraum wird nach Einführen der elektrischen Schaltung 5 und des Kabels 3 sowie nach Durchführung des elektrischen Anschlusses zwischen beiden mit einer durchsichtigen Vergußmasse 11 ausgefüllt. Diese leitet das Licht einer Leuchtdiode 9, die Bestandteil der elektrischen Schaltung 5 ist und zur Schaltzustandsanzeige des Näherungsschalters aufleuchtet. Das Aufleuchten der Leuchtdiode 9 wird an der Stirnseite des Massivkörpers 1 über die neben dem Austritt des Kabels 3 durch die Vergußmasse 11 gebildete Fläche sichtbar.

Auch bei der Ausführungsform gemäß FIG 2 wird vorteilhafterweise unabhängig von der Größe des Sensors 4 der Innenraum 2 volumenmäßig beibehalten, so daß sich auch hier für die unterschiedlichen Ausführungsformen gleich gute Wärmeableitungswege ergeben.

## Patentansprüche

1. Näherungsschalter mit einem zylindrischen Metallgehäuse (1), in dessen Innenraum (2) an einer Stirnseite ein elektrisches Anschlußteil (3) und an der anderen Stirnseite ein Sensor (4) angeordnet ist, mit einer elektrischen Schaltung (5) im Zwischenraum zwischen dem Anschlußteil (3) und dem Sensor (4) und mit einer wärmeleitenden Verbindung zwischen der elektrischen Schaltung (5) und dem Metallgehäuse (1),
**dadurch gekennzeichnet**, daß als Gehäuse ein Vollzylinder (1) mit einem über seine Länge konstanten Außendurchmesser vorgesehen ist, der mit einer Durchgangsöffnung (6,7) versehen ist, die teilweise als Bohrung (6) ausgeführt ist, in die das elektrische Anschlußteil (3) und/oder die elektrische Schaltung (5) eingelegt ist, und die an ihrer dem Anschlußteil (3) abgewandten Seite eine Aufweitung aufweist, in die ein gegenüber dem Durchmesser (D) der Bohrungsöffnung größerer Sensor eingelegt ist, wobei der Durchmesser (D) der Bohrungsöffnung zur Erzielung einer guten Wärmeabfuhr der elektrischen Schaltung über das Gehäuse möglichst klein gehalten ist.

2. Näherungsschalter nach Anspruch 1, **dadurch gekennzeichnet**, daß die Ausweitung als zweite zur ersten Bohrung (6) axialsymmetrische Bohrung (7) ausgeführt ist.

3. Näherungsschalter nach einem der vorangehenden Ansprüche, **dadurch gekennzeichnet**, daß der Massivkörper (1) an dem das elektrische Anschlußteil (3) aufweisenden Ende axialsymmetrisch zur ersten Bohrung (6) ein Außengewinde (8) aufweist.

4. Näherungsschalter nach Anspruch 3, **dadurch gekennzeichnet**, daß der Massivkörper im Bereich des elektrischen Anschlußteils (3) zu einem hülsenförmigen Abschnitt verjüngt ist, der das Außengewinde (8) trägt.

5. Näherungsschalter nach einem der vorangehenden Ansprüche, **dadurch gekennzeichnet**, daß der Näherungsschalter eine Schaltzustandsanzeige aufweist.

6. Näherungsschalter nach einem der vorangehenden Ansprüche 1-6, **dadurch gekennzeichnet**, daß das elektrische Anschlußteil (3) als lichtleitender Steckereinsatz (3) ausgeführt ist, der das Licht einer Leuchtdiode (9) im Innenraum (2) zu mindestens einer dritten Bohrung (10) im Massivkörper (1) überträgt, durch die das Licht der Leuchtdiode (9) von außen her erkennbar ist.

7. Näherungsschalter nach Anspruch 6, **dadurch gekennzeichnet**, daß die dritte Bohrung (10) vom Innenraum nach außen im hülsenförmigen Abschnitt des Massivkörpers (1) vogesehen ist.

8. Näherungsschalter nach einem der Ansprüche 1-4, **dadurch gekennzeichnet**, daß als elektrisches Anschlußteil ein Kabel (3) mit einem gegenüber D kleineren Außendurchmesser vorgesehen ist und daß der Innenraum (2) mit einer durchsichtigen Vergußmasse (11) vergossen ist, über die das Licht einer Leuchtdiode (9) im Innenraum (2) zu der zwischen dem Massivkörper (1) und dem Kabel (3) befindlichen Fläche am Austritt des Kabels (3) übertragbar ist.

## Claims

1. Proximity switch having a cylindrical metal housing (1), in the interior (2) of which at a front side an electrical terminal (3) is arranged and at the other front side a sensor (4) is arranged, having an electrical circuit (5) in the space between the terminal (3) and the sensor (4) and having a heat-conducting connection between the electrical circuit (5) and the metal housing (1), characterized in that as housing a solid cylinder (1) with an external diameter which is constant over its length is provided, which is provided with a feed-through opening (6, 7), which is partially designed as a bore (6), into which the electrical terminal (3) and/or the electrical circuit (5) are inserted, and which has a widening at its side directed away from the terminal (3), into which widening a sensor is inserted which is larger compared with the diameter (D) of the bore opening, whereby the diameter (D) of the bore opening is kept as small as possible to attain good removal of heat of the electrical circuit by way of the housing.

2. Proximity switch according to claim 1, characterized in that the widening is designed as a second bore (7) axisymmetrical to the first bore (6).

3. Proximity switch according to one of the preceding claims, characterized in that at the end having the electrical terminal (3) the solid body (1) has an external thread (8) axisymmetrically to the first bore (6).

4. Proximity switch according to claim 3, characterized in that the solid body in the region of the electrical terminal (3) is tapered to a sleeve-shaped section which supports the external thread (8).

5. Proximity switch according to one of the preceding claims, characterized in that the proximity switch has a switching-state display.

6. Proximity switch according to one of the preceding claims 1-5, characterized in that the electrical terminal (3) is designed as light-guiding plug insert (3) which transmits the light of a light diode (9) in the interior (2) to at least a third bore (10) in the solid body (1), through which the light of the light diode (9) can be recognized from the outside.

7. Proximity switch according to claim 6, characterized in that the third bore (10) from the interior to the outside is provided in the sleeve-shaped section of the solid body (1).

8. Proximity switch according to one of claims 1-4, characterized in that a cable (3) with an external diameter which is smaller compared with D is provided as electrical terminal and in that the interior (2) is filled with a transparent casting compound (11) by way of which the light of a light diode (9) in the interior (2) can be transmitted to the surface located between the solid body (1) and the cable (3) at the outlet of the cable (3).

## Revendications

1. Détecteur de proximité comportant un boîtier métallique (1) cylindrique, à l'intérieur (2) duquel est montée une partie (3) de raccordement électrique d'un côté frontal et un capteur (4) de l'autre côté frontal, un circuit électrique (5) dans l'espace compris entre la partie (3) de raccordement et le capteur (4) et une liaison conductrice de la chaleur entre le circuit électrique (5) et le boîtier (1) métallique,
caractérisé en ce qu'il est prévu comme boîtier un cylindre (1) plein, qui a un diamétre extérieur constant sur toute sa longueur et qui est muni d'une ouverture (6,7) de passage, laquelle est réalisée en partie comme perçage (6) et dans laquelle la partie (3) de raccordement électrique et/ou le circuit (5) électrique est mis et qui comporte de son côté éloigné de la partie (3) de raccordement un élargissement, dans lequel un capteur plus grand que le diamètre (D) de l'ouverture du perçage est mis, le diamètre (D) de l'ouverture du perçage étant maintenu le plus petit possible pour obtenir une bonne évacuation de la chaleur du circuit électrique par l'intermédiaire du boîtier.

2. Détecteur de proximité suivant la revendication 1, caractérisé en ce que l'élargissement est réalisé en tant que deuxième perçage (7) axialement symétrique du premier perçage (6).

3. Détecteur de proximité suivant l'une des revendications précédentes, caractérisé en ce que le corps plein (1) comporte un filetage (8) axialement symétrique du premier perçage (6) à l'extrémité comportant la partie (3) de raccordement électrique.

4. Détecteur de proximité suivant la revendication 3, caractérisé en ce que le corps plein se rétrécit dans la zone de la partie (3) de raccordement électrique en un tronçon en forme de douille qui porte le filetage (8).

5. Détecteur de proximité suivant l'une des revendications précédentes, caractérisé en ce que le détecteur de proximité comporte un affichage d'état de commutation.

6. Détecteur de proximité suivant l'une des revendications 1 à 5 précédentes, caractérisé en ce que la partie (3) de raccordement électrique est réalisée en tant qu'insert d'enfichage guidant la lumière, qui transmet la lumière d'une diode (9) luminescente à l'intérieur d'au moins un troisième perçage (10) dans le corps plein (1), au travers duquel on peut reconnaître de l'extérieur la lumière de la diode luminescente (9).

7. Détecteur de proximité suivant la revendication 6, caractérisé en ce que le troisième perçage (10) est prévu de l'intérieur vers l'extérieur dans le tronçon en forme de douille du corps (1) plein.

8. Détecteur de proximité suivant l'une des revendications 1 à 4, caractérisé en ce qu'il est prévu comme partie de raccordement électrique un cable (3) ayant un diamètre extérieur plus petit que D et l'intérieur (2) est scellé par une masse (11) de scellement transparente, par laquelle la lumière d'une diode luminescente (9) à l'intérieur (2) peut être transmise à la surface se trouvant entre le corps (1) plein et le câble (3) à la sortie du câble (3).
